Europäisches Patentamt

European Patent Office

Office européen des brevets

(19)

(11) Veröffentlichungsnummer: **0 271 077 B1**

(12) **EUROPÄISCHE PATENTSCHRIFT**

(45) Veröffentlichungstag der Patentschrift: **28.08.91**

(21) Anmeldenummer: **87118228.3**

(22) Anmeldetag: **17.07.85**

(51) Int. Cl.⁵: **C08F 220/18**, C08F 220/04, //(C08F220/18,220:04), (C08F220/04,220:18)

(60) Veröffentlichungsnummer der früheren Anmeldung nach Art. 76 EPÜ: **0 173 057**

(54) **Mischpolymerisat einer Alpha-Beta-ungesättigten Carbonsäure und Verfahren zu seiner Herstellung.**

(30) Priorität: **26.07.84 DE 3427519**

(43) Veröffentlichungstag der Anmeldung:
**15.06.88 Patentblatt 88/24**

(45) Bekanntmachung des Hinweises auf die Patenterteilung:
**28.08.91 Patentblatt 91/35**

(84) Benannte Vertragsstaaten:
**AT BE CH DE FR GB IT LI NL SE**

(56) Entgegenhaltungen:
**DE-A- 1 619 150**
**DE-A- 2 363 806**
**DE-A- 2 509 473**
**DE-A- 3 028 136**
**US-A- 3 554 913**

(73) Patentinhaber: **HOECHST AKTIENGESELL-SCHAFT**
**Postfach 80 03 20**
**W-6230 Frankfurt am Main 80(DE)**

Patentinhaber: **RÖHM GMBH Chemische Fabrik**
**Kirschenallee**
**W-6100 Darmstadt(DE)**

(72) Erfinder: **Geissler, Ulrich, Dr. Dipl.-Ing.**
**Altenauer Strasse 34**
**W-6203 Hochheim/Main(DE)**
Erfinder: **Albrecht, Klaus, Dr. Dipl.-Ing.**
**Vogelsbergstrasse 20**
**W-6500 Mainz 42(DE)**

(74) Vertreter: **Euler, Kurt Emil, Dr. et al**
**HOECHST AG - Werk KALLE Patentabteilung**
**Postfach 3540 Rheingaustrasse 190**
**W-6200 Wiesbaden(DE)**

## Beschreibung

Die Erfindung betrifft ein wasserunlösliches, in wäßrig-alkalischen Lösungen lösliches Mischpolymerisat aus einer α,β-ungesättigten Carbonsäure und einem Alkylmethacrylat mit mindestens 4 Kohlenstoffatomen in der Alkylgruppe, das insbesondere als Bindemittel für photopolymerisierbare Gemische geeignet ist.

Mischpolymerisate der genannten Gattung sind bekannt und werden u. a. zur Herstellung von photopolymerisierbaren Gemischen für Druckplatten und Photoresistmaterialien verwendet. Ein bevorzugtes Anwendungsgebiet für derartige Gemische ist die Herstellung von Trockenphotoresistmaterialien.

In der DE-A 20 64 080 sind derartige Gemische beschrieben, die als Bindemittel Mischpolymerisate von Methacrylsäure und Alkylmethacrylaten mit mindestens 4 Kohlenstoffatomen in der Alkylgruppe, bevorzugt Terpolymerisate von Methacrylsäure, Methyl- oder Ethylmethacrylat und einem Alkylmethacrylat mit 4 bis 15 Kohlenstoffatomen in der Alkylgruppe enthalten. Für diese Mischpolymerisate werden Molekulargewichte von 20.000 bis 200.000 angegeben. Ihre Herstellung erfolgt dort durch Polymerisation der Monomeren in einem organischen Lösemittel. Bei der dort beschriebenen Variante der Lösungspolymerisation wird ein Lösemittel gewählt, aus dem das gebildete Polymerisat ausfällt. Hierbei werden Polymerisate erhalten, deren Molekulargewicht im allgemeinen nicht höher als etwa 35.000 ist. Diese Gemische bilden gut haftende, flexible Schichten, die aber in höheren Dicken, etwa oberhalb 20 μm, zu kaltem Fluß neigen und deshalb bei längerer Lagerung in Form von beschichteten, aufgewickelten Trockenresistfolien am Rand austreten und verkleben.

In der DE-A 23 63 806 sind ähnliche Gemische beschrieben, die Terpolymerisate aus Methacrylsäure, einem Alkylmethacrylat mit mindestens 4 Kohlenstoffatomen in der Alkylgruppe und einem weiteren Monomeren enthalten, dessen zugehöriges Homopolymerisat eine Glastemperatur von mindestens 80 °C aufweist. Als solche Monomere werden insbesondere Styrol, substituierte Styrole und Acrylnitril genannt. Diese Gemische haben einen erheblich reduzierten kalten Fluß, sie sind jedoch für bestimmte Anwendungen, wie das Überspannen von Löchern im Basismaterial, die sogenannte Tenting-Technik, nur beschränkt oder gar nicht geeignet. Die Tenting-Technik wird in zunehmendem Maße zur Herstellung von Leiterplatten eingesetzt. Bei der Verarbeitung nach dem Subtraktiv-Verfahren werden die gebohrten und gebürsteten Platten in den Bohrungen chemisch metallisiert und dann im galvanischen Kupferbad über die gesamte Oberfläche auf die geforderte Endschichtdicke verstärkt. Danach wird mit Photoresist laminiert und anschließend belichtet. Dabei wird die Resistschicht in den Bereichen der Leiterzüge und Lötaugen gehärtet. Die Bohrungen werden beidseitig durch gehärtete Resistbereiche überdeckt, die beim Entwickeln der Schicht zurückbleiben. Die freigelegten Bereiche der Kupferschicht werden weggeätzt.

Die Tenting-Technik ist außerdem beim Abdecken von sogenannten Greif- bzw. Positionslöchern von Wichtigkeit. Dies sind Löcher mit einem Durchmesser bis zu 6 mm und darüber, die in den Platten für die Handhabung bei verschiedenen Behandlungsschritten vorgesehen sind. Bei dem semiadditiven Verfahren wird an den nicht von der Resistschablone abgedeckten Bereichen galvanisch Metall abgeschieden. Hierbei müssen auch die Positionslöcher abgedeckt sein, da sie sonst durch Metallabscheidung verengt und damit für weitere Schritte unbrauchbar gemacht würden. Danach wird die Resistschablone entfernt und das darunterliegende Leitkupfer mit einem Ätzmittel fortgeätzt, wobei auch das in den Greif- bzw. Positionslöchern vorhandene Kupfer entfernt wird.

Die Tenting-Technik stellt somit hohe Anforderungen an den Photoresist. Er muß im belichteten Zustand flexibel sowie ätz- und galvanoresistent sein und Bohrungen von 6 mm und mehr freitragend überdecken.

Aufgabe der Erfindung war es, ein Mischpolymerisat vorzuschlagen, das als Bindemittel für zur Herstellung von Trockenphotoresistmaterialien geeigneten photopolymerisierbaren Gemischen geeignet ist, die sich leicht und vollständig mit wäßrig-alkalischen Lösungen entwickeln lassen, Schichten mit hoher Flexibilität und geringem kalten Fluß bilden und die ferner geeignet sind, beim Laminieren auf gebohrte kupferbeschichtete Isolierstoffplatten Bohrlöcher von mehr als 1 mm Durchmesser zu überspannen und in Form des so entstandenen selbsttragenden Films nach dem Belichten weitere Behandlungsschritte, wie die Sprühentwicklung, das Ätzen und Galvanisieren, ohne Beschädigung zu überstehen.

Gegenstand der Erfindung ist ein Mischpolymerisat aus (l) einer α,β-ungesättigten aliphatischen Carbonsäure, (2) einem Alkylmethacrylat mit mindestens 4 Kohlenstoffatomen in der Alkylgruppe und gegebenenfalls (3) mindestens einer mit der ungesättigten Carbonsäure (1) und dem Alkylmethacrylat (2) mischpolymerisierbaren monomeren ethylenisch ungesättigten Verbindung, deren zugehöriges Homopolymerisat eine Glastemperatur von mindestens 80 °C hat, wobei die α,β-ungesättigte Carbonsäure ein Homopolymerisat mit einer Glastemperatur oberhalb 80 °C bildet, wenn die Verbindung (3) fehlt.

Das erfindungsgemäße Mischpolymerisat ist dadurch gekennzeichnet, daß es ein mittleres Molekulargewicht im Bereich von etwa 50.000 bis 200.000 hat und durch Polymerisation in der Masse hergestellt

2

EP 0 271 077 B1

worden ist.

Schichten mit guter Flexibilität und Zähigkeit bei gleichzeitig ausreichender Entwickelbarkeit in wäßrig-galkalischen Lösungen werden mit solchen Mischpolymerisaten erhalten, die ein Molekulargewicht von 65.000 bis 150.000 haben.

Das Mischpolymerisat enthält als ungesättigte aliphatische Carbonsäure (1) bevorzugt Acrylsäure, Methacrylsäure, Crotonsäure, Sorbinsäure, Maleinsäure, Itaconsäure oder Halbester der genannten Dicarbonsäuren. Als ganz besonders vorteilhaft hat sich die Methacrylsäure erwiesen.

Das Alkylmethacrylat (2) hat vorzugsweise 4 bis 20, insbesondere 6 bis 12, Kohlenstoffatome in der Alkylgruppe. Sein zugehöriges Homopolymerisat soll bevorzugt eine Glastemperatur von höchstens 20 °C aufweisen.

Mischpolymerisate, die allein aus den Komponenten (1) und (2) bestehen, sind als Bindemittel geeignet, wenn die ungesättigte Carbonsäure (1) ein Homopolymerisat mit einem Tg-Wert oberhalb 80 °, bevorzugt von mindestens 100 °C, bildet. Mit dem Säuregehalt steigt die Glastemperatur dieser Mischpolymerisate auch ohne Zusatz einer Komponente (3). Mischpolymerisate mit höherer Glastemperatur ermöglichen wiederum eine Erhöhung des Monomeranteils in der Schicht, ohne daß es zu kaltem Fluß kommt. In der Regel werden für viele Anwendungen diese Mischpolymerisate aus zwei Komponenten bevorzugt, da sie sich einfach herstellen und in ihrer Zusammensetzung leichter reproduzieren lassen als Mischpolymerisate aus drei oder mehr Komponenten.

In vielen Fällen, in denen es erwünscht ist, die Glastemperatur des Mischpolymerisats unabhängig von dessen Säurezahl zu variieren oder in denen andere Eigenschaften gezielt beeinflußt werden sollen, ist es aber vorteilhaft, ein weiteres Monomeres (3) einzusetzen, das Homopolymerisate mit Tg-Werten von mindestens 80 °C, bevorzugt mindestens 100 °C, bildet. Als solche Monomere sind z. B. geeignet:

Styrol oder substituierte Styrole, wie Vinyltoluol, 4-Chlorstyrol, Propen-2-yl-benzol, Vinyl-ethyl-benzol, 2-Methoxy-styrol; Vinylnaphthalin oder substituierte Vinylnaphthaline; Vinylheterocyclen wie N-Vinylcarbazol, Vinylpyridin, Vinyloxazol; Vinylcycloalkane wie Vinylcyclohexan und 3,5-Dimethylvinylcyclohexan; Acrylamid, Methacrylamid, N-substituierte Acrylamide bzw. Methacrylamide, Acrylnitril, Methacrylnitril und Arylmethacrylate.

Bevorzugt werden Styrol oder substituierte Styrole, Acrylamid, Methacrylamid, Acrylnitril und Methacrylnitril, insbesondere Styrol.

Selbstverständlich können von den Komponenten (1), (2) und (3) auch jeweils mehrere Vertreter enthalten sein.

Der Mengenanteil der Komponente (1) beträgt im allgemeinen 20 bis 60, bevorzugt 30 bis 55 mol-%; der Mengenanteil an Komponente (2) je nach Kettenlänge 25 bis 80, vorzugsweise 35 bis 65 und der Mengenanteil an Komponente (3) 0 bis 30, bevorzugt 3 bis 20 mol-%. Die Gesamtmenge an Monomeren mit zugehörigen Tg-Werten von mindestens 80 °C, also von (1) und (3), beträgt bevorzugt mindestens 35 mol-%. Die Säurezahl des Mischpolymerisats liegt vorzugsweise im Bereich von 170-250.

Damit die Mischpolymerisate den Anforderungen an die Verarbeitung im Trockenresistverfahren genügen, ist es erforderlich, daß ihre Glastemperatur Tg innerhalb eines bestimmten Bereichs liegt. Die Tg-Werte von Mischpolymerisaten lassen sich näherungsweise aus den Tg-Werten der Homopolymerisate der einzelnen Komponenten nach der folgenden Formel berechnen:

$$\frac{100}{Tg_{MP}} = \frac{m_A}{Tg_A} + \frac{m_B}{Tg_B} + \frac{m_C}{Tg_C} + \cdots$$

Dabei bedeuten

$Tg_{MP}$     Glastemperatur des Mischpolymerisats (in Kelvin)
$Tg_{A (B, C ..)}$     Glastemperatur des Homopolymerisats von A (B, C usw.) (in Kelvin)
$m_{A (B, C ..)}$     Mengenanteil an A (B, C usw.) im Mischpolymerisat in Gew.-%.

Die Tg-Werte des Mischpolymerisats in dem erfindungsgemäßen Gemisch sollten im allgemeinen zwischen 35 und 70 °C, bevorzugt zwischen 40 und 60 °C, liegen.

Die Mischpolymerisate werden durch Polymerisation in der Masse, d. h. ohne Zusatz von wesentlichen Mengen Lösungs- oder Dispergierhilfsmitteln, in Gegenwart eines radikalbildenden Polymerisationsinitiators hergestellt.

Die Herstellung erfolgt in üblicher Weise in flachen Behältern, um eine bessere Temperaturkontrolle zu ermöglichen. Als Initiatoren werden in bekannter Weise Peroxide oder Azoverbindungen verwendet, die beim Erwärmen Radikale bilden. Um eine gleichmäßige Molekulargewichtsverteilung zu erhalten, ist es

3

zweckmäßig, eine kleine Menge eines Kettenreglers, z. B. einer Mercaptoverbindung zuzusetzen. Auch kann man eine kleine Menge, z. B. weniger als 10 Gew.-% des Monomerengemisches eines Lösungsmittels, z. B. Wasser oder einen niederen Alkohol, zusetzen. Die Temperatur kann zwischen etwa 30 und 130 °C liegen.

Das Herstellungsverfahren hat offenbar wesentlichen Einfluß auf die Flexibilität und Elastizität des Mischpolymerisats, d. h. die Eigenschaften, die für den Einsatz des Gemisches als Trockenresist für die Tenting-Technik wesentlich sind.

Die die erfindungsgemäßen Mischpolymerisate enthaltenden photopolymerisierbaren Gemische sind in der früheren Patentanmeldung 85 10 8927.6, Veröffentlichungsnummer 173 057, beschrieben und beansprucht. Sie enthalten ferner polymerisierbare Verbindungen mit mindestens zwei endständigen ethylenischen Doppelbindungen. Als polymerisierbare Verbindungen werden im allgemeinen Ester der Acryl-oder Methacrylsäure mit mehrwertigen, vorzugsweise primären, Alkoholen verwendet.

Besonders geeignet sind Urethangruppen enthaltende Bisacrylate und Bismethacrylate, die durch Umsetzung von 1 mol eines Diols mit 2 mol eines Diisocyanats und 2 mol Hydroxyalkylacrylat oder -methacrylat erhalten werden. Derartige Urethangruppen enthaltende Monomere sind in der DE-A 28 22 190 beschrieben. Ähnliche Monomere sind in der DE-A 30 48 502 beschrieben.

Die photopolymerisierbaren Gemische enthalten außerdem durch Strahlung, insbesondere aktinisches Licht aktivierbare Polymerisationsinitiatoren. Beispiele sind Benzoin und seine Derivate, Trichlormethyl-s-triazine, Trihalogenmethylgruppen enthaltende Carbonylmethylenheterocyclen, Acridinderivate, Phenazinderivate und Chinoxalinderivate. Die Initiatoren werden allgemein in einer Menge von 0,01 bis 10, vorzugsweise von 0,05 bis 4 Gew.-%, bezogen auf die nicht flüchtigen Bestandteile des Gemisches, eingesetzt.

Das photopolymerisierbare Gemisch enthält im allgemeinen 30 bis 70, bevorzugt 40 bis 60, Gew.-% erfindungsgemäßes Bindemittel und 30 bis 70, bevorzugt 40 bis 60 Gew.-% polymerisierbare Verbindungen, bezogen jeweils auf die Gesamtmenge an nicht flüchtigen Bestandteilen.

Als Schichtträger für mit dem photopolymerisierbaren Gemisch hergestellte Aufzeichnungsmaterialien sind beispielsweise Aluminium, Stahl, Zink, Kupfer, Siebe oder Kunststoffolien, geeignet.

Das photopolymerisierbare Gemisch findet bevorzugt Anwendung als trocken übertragbares Photoresistmaterial, wobei es sich insbesondere bei Anwendung der Tenting-Technik bewährt.

Im allgemeinen wird zur Herstellung des Trockenresistmaterials eine Lösung des Gemisches in einem Lösemittel auf einen geeigneten Schichtträger, z. B. eine Polyesterfolie, aufgebracht und getrocknet. Die freie Oberfläche der Schicht wird vorzugsweise mit einer Deckfolie, z. B. aus Polyethylen oder Polypropylen, abgedeckt.

Die Folien lassen sich mit in der Trockenresisttechnik üblichen Geräten verarbeiten. In einer handelsüblichen Laminiervorrichtung wird die Deckfolie abgezogen und die Photoresistschicht auf gebohrtes, verkupfertes Basismaterial auflaminiert. Die so präparierte Platte wird dann durch eine Vorlage belichtet und nach Abziehen der Trägerfolie in bekannter Weise entwickelt.

Die photopolymerisierbaren Gemische werden mit besonderem Vorteil in Form eines Trockenresistfilms zur Herstellung von Reservagen, d. h. Ätzschutzschichten oder Galvanoreserven, auf metallischen Trägern, z. B. Kupfer, verwendet.

Bei dieser Anwendung kommt die herausragende Elastizität und Zähigkeit der aus dem Gemisch hergestellten Photoresistschichten sowohl im unbelichteten als auch im belichteten Zustand zur Geltung. Es ist mit Schichten aus dem photopolymerisierbaren Gemisch möglich, Löcher von 6 mm Durchmesser und darüber zu überspannen, wobei die Schicht beim Abtrennen der Folie, beim Entwickeln, Galvanisieren und bzw. oder Ätzen unbeschädigt bleibt. Trotz des hohen Molekulargewichts der erfindungsgemäßen Mischpolymerisate lassen sich Schichten mit rein wäßrigen, schwach alkalischen Entwicklerlösungen vollständig entwickeln. Die Bindemittel sind mit den üblichen Monomeren in weiteren Mengenverhältnissen besser mischbar als bekannte Bindemittel mit niederem Molekulargewicht; ein Weichmacherzusatz ist nicht erforderlich. In gleicher Form haben die Gemische eine gute Resistenz gegen Entwickler, Ätzlösungen und Galvanisierbäder.

Die folgenden Beispiele erläutern bevorzugte Ausführungsformen der erfindungsgemäßen Mischpolymerisate und ihre Anwendung. Wenn nichts anderes angegeben ist, sind Prozentzahlen und Mengenverhältnisse in Gewichtseinheiten zu verstehen. Gewichtsteile (Gt) und Volumenteile (Vt) stehen im Verhältnis von g zu $cm^3$.

Beispiel 1

Eine Lösung von
6,5 Gt des unten beschriebenen Terpolymerisats,

| 8,8 Gt | eines durch Umsetzung von 1 mol Triethylenglykol, 2 mol 2,2,4-Trimethyl-hexamethylendiisocyanat und 2 mol Hydroxyethylmethacrylat hergestellten polymerisierbaren Diurethans, |
| 0,25 Gt | 9-Phenylacridin und |
| 0,025 Gt | eines blauen Farbstoffs, erhalten durch Kuppeln von 2,4-Dinitro-6-chlor-benzoldiazoniumsalz mit 2-Methoxy-5-acetylamino-N,N-diethylanilin in |
| 15 Gt | Butanon und |
| 15 Gt | Ethanol |

wurde auf eine biaxial verstreckte und thermofixierte Polyethylenterephthalatfolie der Stärke 25 $\mu$m so aufgeschleudert, daß nach dem Trocknen bei 100 °C ein Schichtgewicht von 45 g/m² erhalten wurde.

Das Terpolymerisat wurde wie folgt hergestellt: Eine Monomerenmischung aus n-Hexylmethacrylat, Methacrylsäure und Styrol im Gewichtsverhältnis 60:30:10 wurde mit 0,05 Gew.-% Azoisobuttersäurenitril, 0,02 Gew.-% tert.-Butylperisononanat und 0,5 Gew.-% tert.- Dodecylmercaptan vermischt und zur Polymerisation in flache Hohlkammern aus Stahlblech verfüllt. Das Gemisch wurde im Wasser- oder Luftbad bis zur Verfestigung auf 50 °C erhitzt. Zur Erzielung eines ausreichend hohen Endumsatzes wurde noch auf 100 °C erhitzt und einige Zeit bei dieser Temperatur gehalten. Nach dem Abkühlen wurden die Hohlkammern geöffnet und die entnommenen Polymerblöcke mechanisch zerkleinert. Es wurde ein Polymeres mit einer kinematischen Viskosität $\nu$ von 32 mm²/s (15 % in Ethanol) erhalten; das mittlere Molekulargewicht $\overline{M}_w$, durch Lichtstreuung gemessen, betrug 128.000. Die Säurezahl war 195 und der Umsatz größer als 97 %.

Die so hergestellte Trockenresistfolie wurde mit einer handelsüblichen Laminiervorrichtung bei 115 °C auf eine mit 35 $\mu$m starker Kupferfolie kaschierte Phenoplast-Schichtstoffplatte laminiert und mittels einer 5-kW-Metallhalogenidlampe im Abstand von 110 cm zwischen Lampe und Vakuumkopierrahmen 80 s belichtet. Als Vorlage diente eine Strichvorlage mit Linienbreiten und Abständen bis herab zu 80 $\mu$m.

Nach der Belichtung wurde die Polyesterfolie abgezogen und die Schicht mit 1%iger Natriumcarbonatlösung in einem Sprühentwicklungsgerät 120 s lang entwickelt.

Die Platte wurde dann 30 s mit Leitungswasser gespült, 30 s in einer 15%igen Ammoniumperoxydisulfat-Lösung angeätzt, erneut mit Wasser gespült, 30 s in 10%ige Schwefelsäure getaucht und sodann nacheinander in den folgenden Elektrolytbädern galvanisiert:

1. 60 min in einem Kupferelektrolytbad der Firma Schlötter, Geislingen/Steige, Typ "Glanzkupfer-Bad"
Stromdichte: 2,5 A/dm²
Metallaufbau: ca. 30 $\mu$m
Temperatur: Raumtemperatur
2. 15 min in einem Bleizinnbad LA der Firma Schlötter, Geislingen/Steige
Stromdichte: 2 A/dm²
Metallaufbau: 15 $\mu$m
Temperatur: Raumtemperatur

Die Platte zeigte keinerlei Unterwanderungen oder Beschädigungen.

Die Platte konnte sodann in 5%iger KOH-Lösung bei 50 °C entschichtet und das freigelegte Kupfer in den üblichen Ätzmedien weggeätzt werden.

In einem anderen Versuch wurde die Photoresistschicht auf eine mit Kupfer kaschierte Testplatte mit Bohrungen zwischen 1 und 6 mm Durchmesser auflaminiert und der Resist durch eine den Bohrungen entsprechende Negativvorlage (Durchmesser der transparenten Stellen 1,4 bis 6,4 mm) belichtet. Anschließend wurden die nicht belichteten Schichtteile mit 1%iger Natriumcarbonatlösung ausgewaschen und das freigelegte Kupfer mit ammoniakalischer Kupferchloridlösung weggeätzt. Nach dem Ätzen waren alle Bohrlöcher mit gehärtetem Photoresist überspannt.

Zum Vergleich wurde das erfindungsgemäße Bindemittel durch ein analoges mit einem Molekulargewicht von ca. 33.000 [$\nu$(15%ig in Ethanol) = 11 mm²/s] gemäß DE-A 23 63 806 ersetzt, das durch Polymerisation in 33%iger Lösung in Butanon hergestellt worden war. Es wurde eine klebrige Photoresistschicht erhalten, die nur schwer zu verarbeiten ist. Durch die geringere schichtverfestigende Wirkung des niedermolekularen Bindemittels trat beim Lagern von Resistrollen, insbesondere bei erhöhten Temperaturen, Schichtsubstanz an den Schnittkanten aus. Beim Laminieren auf ein mit Bohrungen versehenes Basismaterial bildete sich um jedes Bohrloch ein Ring mit geringerer Schichtdicke aus. Eine derartige Schicht war nicht für die Tenting-Technik einsetzbar.

Auch die in der DE-A 23 63 806, Beispiel 4, oder der DE-A 28 22 190, Beispiel 1, beschriebenen Trockenresistschichten, die beide das obige Bindemittel enthalten, sind nicht zum Überspannen von mehr als 1 mm weiten Bohrlöchern geeignet.

Beispiel 2

EP 0 271 077 B1

In der in Beispiel 1 beschriebenen Beschichtungslösung wurden statt des dort beschriebenen Bindemittels gleiche Mengen der folgenden Terpolymeren eingesetzt:

a) Terpolymerisat aus n-Hexylmethacrylat, Methacrylsäure und Styrol (60:30:10) mit einem mittleren Molekulargewicht ($\overline{M}_w$) von ca. 185.000, einer kinematischen Viskosität $\nu$(15%ig in Ethanol) von 74 mm²/s und einer Säurezahl von 195,

b) Terpolymerisat aus n-Hexylmethacrylat, Methacrylsäure und Styrol (60:35:5) mit einem $\overline{M}_w$ von 74.000, einer kinematischen Viskosität $\nu$(15%ig in Ethanol) von 23 mm²/s und einer Säurezahl von 228,

c) Terpolymerisat aus n-Hexylmethacrylat, Methacrylsäure und Styrol (60:35:5) mit einem $\overline{M}_w$ von 94.000, einer kinematischen Viskosität $\nu$(15%ig in Ethanol) von 32 mm²/s und einer Säurezahl von 228.

d) Terpolymerisat aus n-Hexylmethacrylat, Methacrylsäure und Methylmethacrylat (60:35:5) mit einer kinematischen Viskosität $\nu$(15%ig in Ethanol) von 36 mm²/s und einer Säurezahl von 228.

e) Copolymerisat aus n-Hexylmethacrylat und Methacrylsäure (65:35) mit einer kinematischen Viskosität $\nu$(15%ig in Ethanol) von 34 mm²/s und einer Säurezahl von 228.

In allen Fällen wurde eine einwandfreie Überspannung der Bohrlöcher (Tenting) erzielt.

## Patentansprüche

1. Mischpolymerisat aus (1) einer $\alpha,\beta$-ungesättigten aliphatischen Carbonsäure, (2) einem Alkylmethacrylat mit mindestens 4 Kohlenstoffatomen in der Alkylgruppe und gegebenenfalls (3) mindestens einer mit der ungesättigten Carbonsäure (1) und dem Alkylmethacrylat (2) mischpolymerisierbaren monomeren ethylenisch ungesättigten Verbindung, deren zugehöriges Homopolymerisat eine Glastemperatur von mindestens 80 °C hat, wobei die $\alpha,\beta$-ungesättigte Carbonsäure ein Homopolymerisat mit einer Glastemperatur oberhalb 80 °C bildet, wenn die Verbindung (3) fehlt, dadurch gekennzeichnet, daß das Mischpolymerisat ein mittleres Molekulargewicht im Bereich von etwa 50.000 bis 200.000 hat und durch Polymerisation in der Masse hergestellt worden ist.

2. Mischpolymerisat nach Anspruch 1, dadurch gekennzeichnet, daß es Einheiten (3) von Styrol oder einem substituierten Styrol enthält.

3. Mischpolymerisat nach Anspruch 1, dadurch gekennzeichnet, daß es 20 bis 60 mol-% Einheiten von $\alpha,\beta$-ungesättigter Carbonsäure (1) enthält.

4. Mischpolymerisat nach Anspruch 1, dadurch gekennzeichnet, daß die $\alpha,\beta$-ungesättigte Carbonsäure (1) Acryl- oder Methacrylsäure ist.

5. Verfahren zur Herstellung eines Mischpolymerisats gemäß Anspruch 1, dadurch gekennzeichnet, daß die Monomeren in Gegenwart eines radikalbildenden Polymerisationsinitiators polymerisiert werden.

6. Verfahren nach Anspruch 5, dadurch gekennzeichnet, daß man einen Kettenregler zusetzt.

## Claims

1. Copolymer comprising (1) an $\alpha,\beta$-unsaturated aliphatic carboxylic acid, (2) an alkyl methacrylate having at least 4 carbon atoms in the alkyl group and optionally (3) at least one monomeric ethylenically unsaturated compound which is copolymerizable with the unsaturated carboxylic acid (1) and the alkyl methacrylate (2) and the associated homopolymer of which has a glass transition temperature of at least 80 °C, the $\alpha,\beta$-unsaturated carboxylic acid forming a homopolymer having a glass transition temperature above 80 °C, if compound (3) is not present, wherein the copolymer has a mean molecular weight in the range from about 50,000 to 200,000 and has been prepared by mass polymerization.

2. The copolymer as claimed in claim 1, which contains units (3) of styrene or a substituted styrene.

3. The copolymer as claimed in claim 1, which contains 20 to 60 mole % of units of $\alpha,\beta$-unsaturated carboxylic acid (1).

4. The copolymer as claimed in claim 1, wherein the $\alpha,\beta$-unsaturated carboxylic acid (1) is acrylic acid or methacrylic acid.

6

**5.** Process for the preparation of a copolymer as claimed in claim 1, wherein the monomers are polymerized in the presence of a polymerization initiator forming free radicals.

**6.** The process as claimed in claim 5, wherein a chain regulator is added.

**Revendications**

**1.** Copolymère de (1) un acide carboxylique aliphatique α,β-insaturé, (2) un méthacrylate d'alkyle ayant au moins 4 atomes de carbone dans le groupe alkyle, et éventuellement (3) au moins un composé monomère à insaturation éthylénique, copolymérisable avec l'acide carboxylique insaturé (1) et le méthacrylate d'alkyle (2), dont l'homopolymère correspondant a une température de transition vitreuse d'au moins 80° C, l'acide carboxylique α,β-insaturé formant un homopolymère ayant une température de transition vitreuse supérieure à 80° C lorsque le composé (3) est absent, caractérisé en ce que le copolymère a une masse moléculaire moyenne dans la plage d'environ 50 000 à 200 000 et a été préparé par polymérisation dans la masse.

**2.** Copolymère selon la revendication 1, caractérisé en ce qu il contient des motifs (3) de styrène ou d'un styrène substitué.

**3.** Copolymère selon la revendication 1, caractérisé en ce qu'il contient de 20 à 60 % en moles de motifs d'acide carboxylique α,β-insaturé (1).

**4.** Copolymère selon la revendication 1, caractérisé en ce que l'acide carboxylique α,β-insaturé (1) est l'acide acrylique ou méthacrylique.

**5.** Procédé pour la préparation d'un copolymère selon la revendication 1, caractérisé en ce que les monomères sont polymérisés en présence d'un initiateur de polymérisation formant des radicaux libres.

**6.** Procédé selon la revendication 5, caractérisé en ce que l'on ajoute un régulateur de longueur de chaîne.